# EUROPEAN PATENT APPLICATION

(11) **EP 4 745 438 A1**
(43) Date of publication of application: **20.05.2026**
(21) Application number: 25214025.6
(22) Date of filing: 06.11.2025
(51) Int. Cl.: F16K 11/085, F01P 7/14, F16K 27/00, F16K 27/06, F16K 27/10

(54) **COOLING MODULE**

(30) Priority: 13.11.2024 JP 2024198460
(71) Applicant: AISIN CORPORATION, Aichi 448-8650 (JP)
(72) Inventor: OSUKA, Shinya, Kariya, 448-8650 (JP); KUROZUMI, Takashi, Kariya, 448-8650 (JP); ISHIKAWA, Katsuhiro, Kariya, 448-8650 (JP); ITAKURA, Emi, Kariya, 448-8650 (JP); KATAOKA, Akihiro, Kariya, 448-8650 (JP)
(74) Representative: Winter, Brandl - Partnerschaft mbB

(57) **Abstract**

A cooling module (1) includes: a manifold housing (10) made of resin and including an accommodation portion (10A, 20A) having an opening (10Aa, 20Aa) and at least a part (15A, 16A, 17A, 21A, 25A) of a flow path (15, 16, 17, 21, 25) allowing a fluid to flow therethrough; a rotary valve (4, 5) accommodated in the accommodation portion via the opening; and a cover body (30) made of resin and resin-bonded to the manifold housing to cover the opening of the accommodation portion and the part of the flow path.

## Description

### TECHNICAL FIELD

This disclosure relates to a cooling module.

### BACKGROUND DISCUSSION

In recent years, automobiles including a motor as a traveling drive source (such as a hybrid electric vehicle (HEV), a plug-in hybrid electric vehicle (PHEV), a battery electric vehicle (BEV), and a fuel cell electric vehicle (FCEV)) having been widespread. These automobiles (hereinafter collectively referred to as "electric vehicles") include a battery for driving the motor. In these electric vehicles, there are plural devices that require cooling such as the motor (including an internal combustion engine such as an engine), the battery, an air conditioner, and an ECU, and thus a cooling circuit for circulating cooling water is provided to cool these devices.

WO 2024/116274A (Reference 1) discloses a cooling module ("manifold" in the document) including a manifold that can be used in an electric vehicle or the like. In the cooling module of Reference 1, a lid portion is joined to a housing body by a bolt or the like to form the manifold.

In the cooling module including the manifold, a rotary valve may be accommodated in an accommodation portion provided in the manifold. In the cooling module having such a configuration, when the lid portion is joined to the accommodation portion provided in the manifold using a bolt, it is necessary to ensure that a portion surrounding the accommodation portion in the manifold or the lid portion has a predetermined thickness for bolt joining. In this case, the cooling manifold increases in height, and the number of components also increases. Therefore, there is room for improvement in the cooling module including the rotary valve accommodated in the manifold.

A need thus exists for a cooling module with a reduced height and a reduced number of components.

### SUMMARY

A cooling module according to this disclosure includes: a manifold housing made of resin and including an accommodation portion having an opening and at least a part of a flow path allowing a fluid to flow therethrough; a rotary valve accommodated in the accommodation portion via the opening; and a cover body made of resin and resin-bonded to the manifold housing to cover the opening of the accommodation portion and the part of the flow path.

According to the cooling module in this configuration, the manifold housing made of resin includes the accommodation portion and at least a part of the flow path that allows a fluid to flow therethrough, the rotary valve is accommodated in the accommodation portion, and the opening of the accommodation portion and the part of the flow path are covered with the cover body, which is made of resin and resin-bonded to the manifold housing. Accordingly, the cooling module does not require a separate member such as a bolt for joining the manifold housing and the cover body. As a result, the height of the cooling module can be reduced, and the number of components can also be reduced.

### BRIEF DESCRIPTION OF THE DRAWINGS

The foregoing and additional features and characteristics of this disclosure will become more apparent from the following detailed description considered with the reference to the accompanying drawings, wherein:
Fig. 1 is a perspective view of a cooling module;
Fig. 2 is an exploded perspective view of the cooling module;
Fig. 3 is a plan view of the cooling module;
Fig. 4 is a partial side cross-sectional view of the cooling module; and
Fig. 5 is a partial side cross-sectional view of a cooling module according to a comparative example.

### DETAILED DESCRIPTION

Hereinafter, an embodiment of a cooling module according to this disclosure will be described in detail with reference to the drawings. The embodiment to be described below is an example for describing this disclosure, and this disclosure is not limited to the embodiment alone. Therefore, this disclosure can be implemented in various forms without departing from the gist of this disclosure.

### Configuration of Cooling System

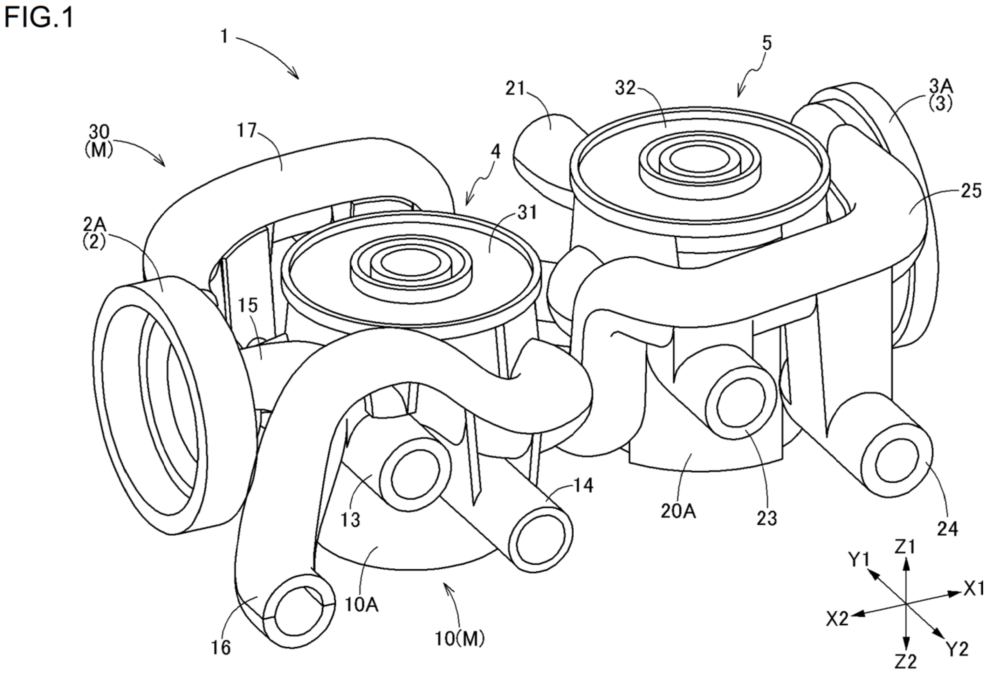

As illustrated in Fig. 1, a cooling system including a cooling module 1 according to the present embodiment includes a first water pump 2, a second water pump 3, a first rotary valve 4, a second rotary valve 5, a radiator, an inverter/motor, a DC-DC converter, a charger, a reserve tank, a heater core, an electric heater, a water-cooled condenser, a battery, a chiller, and a plurality of flow paths for circulating a coolant (an example of a fluid) through these components. The coolant generally refers to either cooling water such as antifreeze or long-life coolant that contains ethylene glycol or the like as a main component, or cooling oil including insulating oil such as paraffin-based oil. Among these, the first water pump 2, the second water pump 3, the first rotary valve 4, and the second rotary valve 5 are attached to the cooling module 1. On the other hand, the radiator, the inverter/motor, the DC-DC converter, the charger, the reserve tank, the heater core, the electric heater, the water-cooled condenser, the battery, and the chiller are disposed apart from the cooling module 1, and the coolant flows between these components and the cooling module 1 through the plurality of flow paths.

The cooling system is used for an automobile including a motor as a traveling drive source (hereinafter, collectively referred to as an "electric vehicle"), such as a hybrid electric vehicle (HEV), a plug-in hybrid electric vehicle (PHEV), a battery electric vehicle (BEV), and a fuel cell electric vehicle (FCEV), and cools the inverter/motor, the battery, or the like by circulating the coolant.

### Configuration of Cooling Module

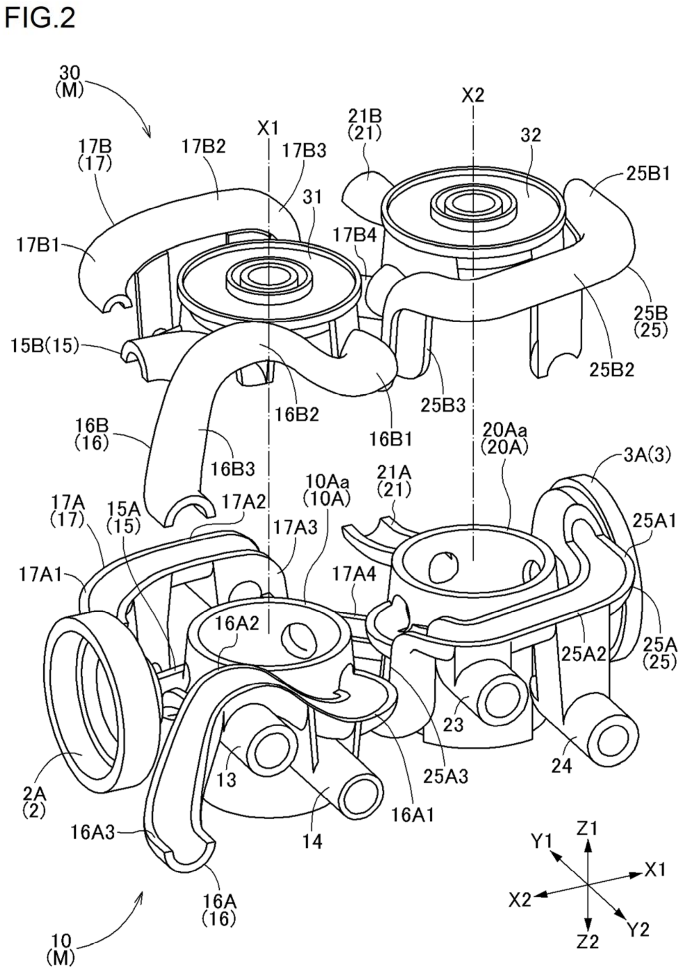

As illustrated in Figs. 1 to 4, the cooling module 1 includes the first water pump 2, the second water pump 3, the first rotary valve 4, the second rotary valve 5, a manifold housing 10 in which a flow path that allows a coolant to flow through these components is formed, and a cover body 30. A manifold M made of resin is formed by resin-bonding the manifold housing 10 and the cover body 30. The first water pump 2 and the second water pump 3 are attached to pump attachment portions 2A and 3A, respectively, and the first water pump 2 and the second water pump 3 are not illustrated in Figs. 1 to 3. In Fig. 2, the first rotary valve 4 and the second rotary valve 5 are not illustrated. In the present embodiment, the manifold housing 10 is made of resin and is formed by a single housing (an example of a "single member"). The cooling module 1 does not include a reserve tank therein. Without the reserve tank, the cooling module 1 can be made compact, and this can provide greater freedom in disposing the cooling module 1.

The manifold housing 10 includes two accommodation portions 10A and 20A and a plurality of flow paths (inflow ports 12, 21, 22, and the like to be described later) formed in a cylindrical shape. In the manifold housing 10, the accommodation portions 10A and 20A have a substantially cylindrical shape. Hereinafter, a direction parallel to an arrangement direction of the two accommodation portions 10A and 20A is defined as an X direction, a direction perpendicular to the X direction is defined as a Y direction, and a direction orthogonal to the X direction and the Y direction is defined as a Z direction. Further, in the X direction, a direction from the first water pump 2 toward the second water pump 3 is defined as an X1 direction, and a direction opposite to the X1 direction is defined as an X2 direction. In the Y direction, a direction from a first outflow port 13 toward a first inflow port 11 is defined as a Y1 direction, and a direction opposite to the Y1 direction is defined as a Y2 direction (the first outflow port 13 and the first inflow port 11 will be described later). In the Z direction, a direction from the manifold housing 10 toward the cover body 30 is defined as a Z1 direction, and a direction opposite to the Z1 direction is defined as a Z2 direction. The Z2 direction is the gravity direction. That is, the manifold housing 10 is disposed below the cover body 30 in a vertical direction.

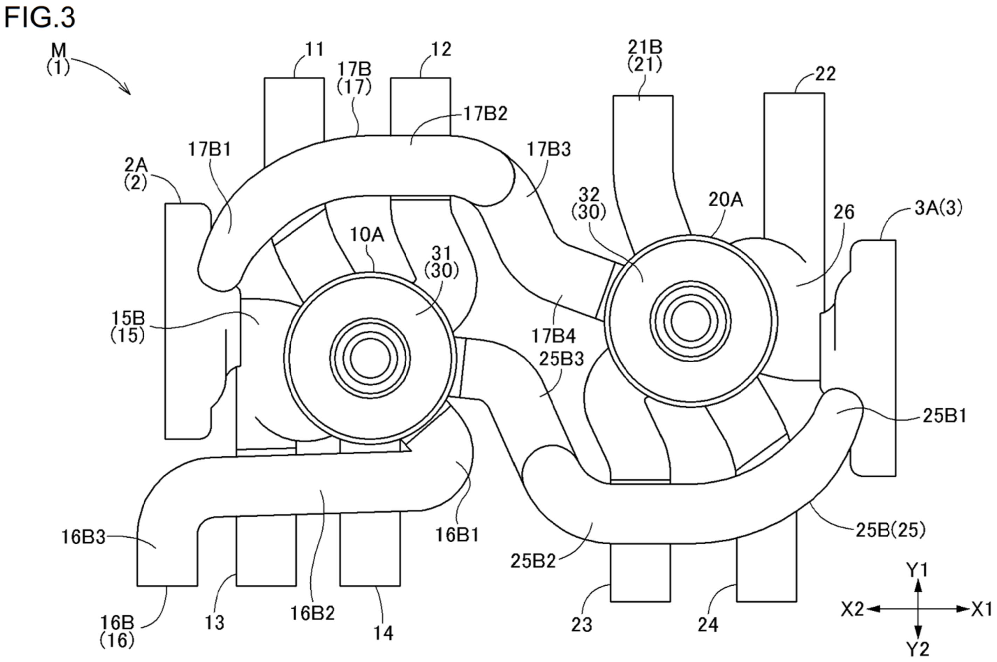

As illustrated in Fig. 3, the first inflow port 11, the second inflow port 12, the first outflow port 13, and a second outflow port 14 are connected to the first accommodation portion 10A. The third inflow port 21, the fourth inflow port 22, a third outflow port 23, and a fourth outflow port 24 are connected to the second accommodation portion 20A. That is, one end of each of the first inflow port 11, the second inflow port 12, the first outflow port 13, and the second outflow port 14 are opened in an inner wall of the first accommodation portion 10A, and one end of each of the third inflow port 21, the fourth inflow port 22, the third outflow port 23, and the fourth outflow port 24 are opened in an inner wall of the second accommodation portion 20A. Each of the inflow ports 11, 12, and 22 and the outflow ports 13, 14, 23, and 24 has a cylindrical shape. The third inflow port 21 is formed by resin-bonding a half-split pipe portion 21A provided in the manifold housing 10 and a half-split pipe portion 21B provided in the cover body 30. The inflow ports 11, 12, 21, and 22 and the outflow ports 13, 14, 23, and 24 have axes thereof aligned in the Y direction and arranged side by side in the X direction, and have openings in the Y1 direction or the Y2 direction.

The cooling module 1 includes a fifth outflow port 16 (an example of a flow path) and flow path pipes 15, 17, 25, and 26 (an example of a flow path) as another port and flow path pipes. The fifth outflow port 16 and the flow path pipes 15, 17, 25, and 26 are formed by resin-bonding half-split pipe portions 15A, 16A, 17A, 25A, and 26A (an example of a part of a flow path) provided in the manifold housing 10 and half-split pipe portions 15B, 16B, 17B, 25B, and 26B provided in the cover body 30, respectively. The first inflow port 11, the second inflow port 12, the first outflow port 13, the second outflow port 14, the third inflow port 21, the fourth inflow port 22, the third outflow port 23, the fourth outflow port 24, the fifth outflow port 16, and the flow path pipes 15, 17, 25, and 26 are all exposed to the outside.

The fifth outflow port 16 is connected to the first accommodation portion 10A above the outflow ports 13 and 14. In the fifth outflow port 16, a base end portion 16B1 is located on the X1 side with respect to the second outflow port 14, and a tip end portion 16B3 is located on the X2 side with respect to the first outflow port 13.

The first flow path pipe 15 is connected to the first water pump 2 and the first accommodation portion 10A. The second flow path pipe 26 is connected to the second water pump 3 and the second accommodation portion 20A. The third flow path pipe 17 is connected to the first water pump 2 and the second accommodation portion 20A. The fourth flow path pipe 25 is connected to the second water pump 3 and the first accommodation portion 10A.

Each of the fifth outflow port 16 and the flow path pipes 17 and 25 has a three-dimensional shape displaced in the X direction, the Y direction, and the Z direction. Specifically, in the fifth outflow port 16, base end portions 16A1 and 16B1 are formed in a direction substantially parallel to an X-Y plane and intersecting both the X1 direction and the Y2 direction, and intermediate portions 16A2 and 16B2 extend from ends of the base end portions 16A1 and 16B1 toward the X2 direction. The intermediate portions 16A2 and 16B2 have a protruding shape in the Z1 direction. Tip end portions 16A3 and 16B3 are formed from ends of the intermediate portions 16A2 and 16B2 toward the Y2 direction. In the third flow path pipe 17, base end portions 17A1 and 17B1 are formed in a direction substantially parallel to the X-Y plane and intersecting both the X1 direction and the Y1 direction, first intermediate portions 17A2 and 17B2 are formed from ends of the base end portions 17A1 and 17B1 toward the X1 direction, second intermediate portions 17A3 and 17B3 are formed from ends of the first intermediate portions 17A2 and 17B2 in a direction intersecting each of the X1 direction, the Y2 direction, and the Z2 direction, and tip end portions 17A4 and 17B4 are formed from ends of the second intermediate portions 17A3 and 17B3 in a direction substantially parallel to the X-Y plane and intersecting both the X1 direction and the Y2 direction. In the fourth flow path pipe 25, base end portions 25A1 and 25B1 are formed in a direction substantially parallel to the X-Y plane and intersecting both the X2 direction and the Y2 direction, first intermediate portions 25A2 and 25B2 are formed in the X2 direction from ends of the base end portions 25A1 and 25B1, second intermediate portions 25A3 and 25B3 are formed in a direction intersecting each of the X2 direction, the Y1 direction, and the Z2 direction from ends of the first intermediate portions 25A2 and 25B2, and tip end portions 25A4 and 25B4 are formed in the X2 direction from ends of the second intermediate portions 25A3 and 25B3. Portions within each of the fifth outflow port 16 and the flow path pipes 17 and 25 (for example, between the base end portions 16A1 and 16B1 and the intermediate portions 16A2 and 16B2) are connected via curved portions that are two-dimensionally or three-dimensionally curved.

In addition to the half-split pipe portions 15B, 16B, 17B, 21B, 25B, and 26B, the cover body 30 includes a first lid portion 31 that covers an opening 10Aa of the first accommodation portion 10A and a second lid portion 32 that covers an opening 20Aa of the second accommodation portion 20A. The cover body 30 is made of resin and is formed using, for example, the same resin material (first resin material) as the manifold housing 10.

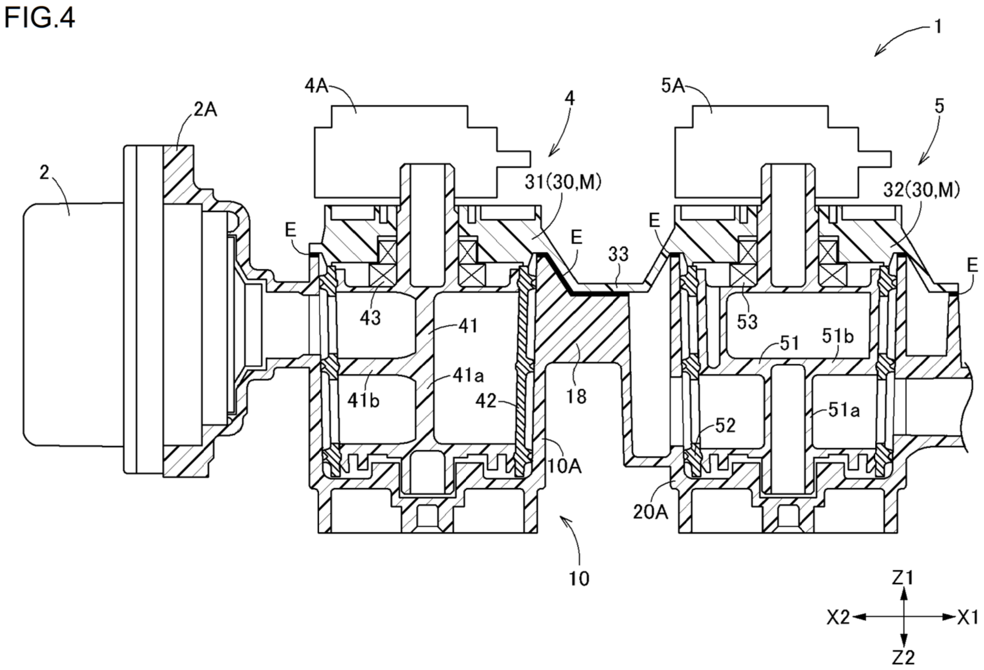

As illustrated in Fig. 4, as the rotary valves 4 and 5, for example, valve rotors 41 and 51, rotor seals 42 and 52, and rod seals 43 and 53 are respectively accommodated in the accommodation portions 10A and 20A provided in the manifold housing 10. The valve rotors 41 and 51 are provided with shaft portions 41a and 51a and plate-shaped flow path partitioning portions 41b and 51b intersecting the shaft portions 41a and 51a. The valve rotors 41 and 51 are rotatably supported by recessed portions formed in bottom surfaces of the accommodation portions 10A and 20A, the rotor seals 42 and 52 provided inside the lid portions 31 and 32, and the like. Actuators 4A and 5A that rotationally drive the valve rotors 41 and 51 are disposed above the valve rotors 41 and 51, respectively. The first rotary valve 4 and the second rotary valve 5 are both electromagnetic valves in which flow paths are switched by the actuators 4A and 5A, respectively, and control a flow of coolant flowing through the plurality of flow paths by rotating the valve rotors 41 and 51 about axes X1 and X2 along the Z direction and switching the flow paths.

As illustrated in Figs. 1 to 4, the pump attachment portions 2A and 3A are provided on both sides of the manifold housing 10 in the X direction, the first water pump 2 is attached to the pump attachment portion 2A, and the second water pump 3 is attached to the pump attachment portion 3A. The first water pump 2 and the second water pump 3 are disposed such that rotation axes thereof are both along the X direction.

As illustrated in Fig. 4, in the cooling module 1, the manifold housing 10 made of resin and the cover body 30 made of resin are resin-bonded to each other at a position where the accommodation portions 10A and 20A are covered, and a resin bonding portion E is provided between the manifold housing 10 and the cover body 30. In the present embodiment, the manifold housing 10 and the cover body 30 are formed of a first resin material, and the resin bonding portion E is formed of a second resin material different from the first resin material. Examples of a resin bonding method of the manifold housing 10 and the cover body 30 include bonding with an adhesive and molding via die slide injection (DSI). In the case of resin bonding via DSI, components of the rotary valves 4 and 5, such as the valve rotors 41 and 51, the rotor seals 42 and 52, and the rod seals 43 and 53, are inserted into the accommodation portions 10A and 20A before a DSI step is performed. Thereafter, the manifold housing 10 and the cover body 30 can be resin-bonded to each other by the DSI method, and the openings of the two accommodation portions 10A and 20A can be covered at the same time. In this case, the second resin material of the resin bonding portion E is the resin used in the DSI method. In Fig. 4, a portion of the manifold housing 10 where the accommodation portion 10A is continuous with the accommodation portion 20A is indicated by a simplified resin portion 18.

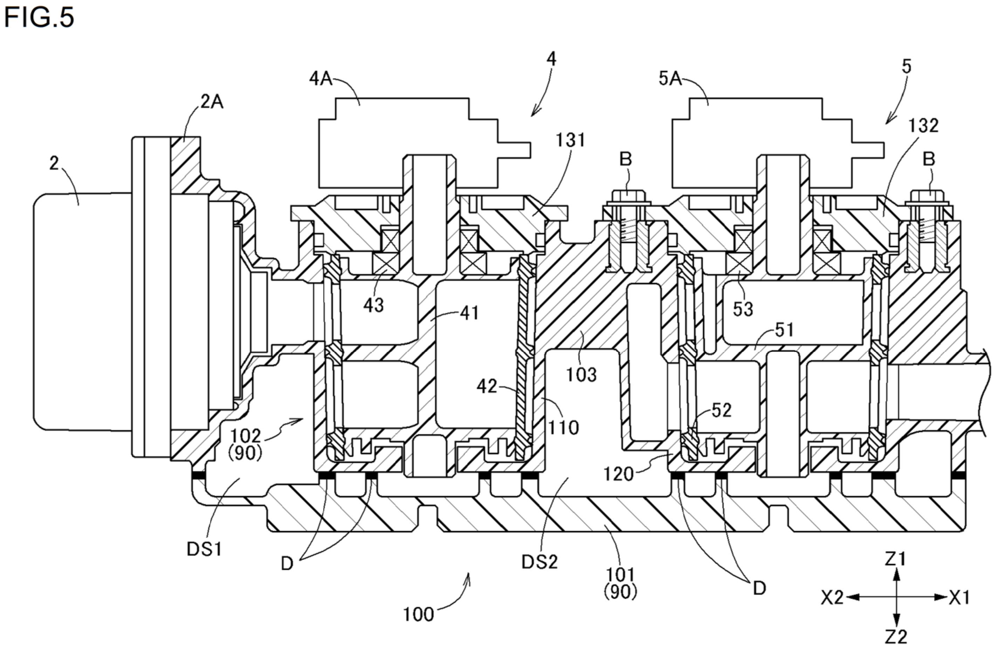

Fig. 5 illustrates a cooling module 100 as a comparative example. As illustrated in Fig. 5, in the cooling module 100, a lower housing 101 and an upper housing 102 constitute a manifold housing 90. The lower housing 101 and the upper housing 102 are, for example, infrared-welded to each other, and have a joining portion D therebetween. In the cooling module 100, two accommodation portions 110 and 120 are formed in the upper housing 102, and, as the rotary valves 4 and 5, the valve rotors 41 and 51, the rotor seals 42 and 52, and the rod seals 43 and 53 are accommodated in the accommodation portions 110 and 120. An upper opening of the accommodation portion 110 is covered with a cover body 131, and an upper opening of the accommodation portion 120 is covered with a cover body 132 that is a member separate from the cover body 131. The accommodation portion 110 and the accommodation portion 120 are connected to each other via a connection portion 103. Here, the cover bodies 131 and 132 that cover the upper openings of the accommodation portions 110 and 120 formed in the upper housing 102 are joined to the upper housing 102 using a bolt B. In Fig. 5, the bolt B for fixing the cover body 131 to the upper housing 102 is not illustrated.

In the cooling module 100 according to the comparative example, the cover bodies 131 and 132 are joined to the upper housing 102 using the bolt B. Therefore, when the bolt B is fixed to peripheries of the accommodation portions 110 and 120, it is necessary to ensure large thicknesses of the cover bodies 131 and 132 and the connection portion 103. Therefore, the cooling module 100 has a structure that easily leads to an increased height in the Z direction. Since the manifold housing 90 includes the lower housing 101 and the upper housing 102, dead spaces DS1 and DS2 may be generated between the lower housing 101 and the upper housing 102. Further, since the accommodation portions 110 and 120 are covered with the cover bodies 131 and 132 as separate members, the number of joining portions using the bolt B increases, and the work takes time.

In contrast, in the cooling module 1 according to the present embodiment illustrated in Fig. 4, the cover body 30 is resin-bonded to the manifold housing 10 at the resin bonding portion E, and the openings 10Aa and 20Aa (see Fig. 2) of the accommodation portions 10A and 20A are covered with the cover body 30. Accordingly, the cooling module 1 does not require a separate member such as a bolt for joining the manifold housing 10 and the cover body 30. As a result, the height of the cooling module 1 can be reduced, and the number of components can also be reduced.

In the cooling module 1 according to the present embodiment illustrated in Fig. 4, the manifold housing 10 is implemented by a single member. Therefore, it is possible to prevent occurrence of a dead space in the flow path formed inside the manifold housing 10.

### Other Embodiments

(1) In the above-described embodiment, as an example, the cooling module 1 is configured such that the manifold housing 10 and the cover body 30 constituting the manifold M are formed of the first resin material, and the resin bonding portion E is formed of the second resin material different from the first resin material. Alternatively, the manifold housing 10, the cover body 30, and the resin bonding portion E may be formed of the same resin material. In this case, the resin bonding portion E can be formed by laser welding, vibration welding, ultrasonic welding, or the like. Even in this case, a separate member such as a bolt is not required for joining the manifold housing 10 and the cover body 30. As a result, the height of the cooling module 1 can be reduced, and the number of components can also be reduced.
(2) In the above embodiment, the cooling module 1 is described as an example in which the manifold housing 10 and the cover body 30 are formed of the same resin material. Alternatively, the manifold housing 10 may be formed of the first resin material, and the cover body 30 may be formed of a resin material different from the first resin material. In this case, the cooling module 1 can be formed by appropriately selecting a resin material corresponding to a portion, for example, by adopting a highly rigid resin for the manifold housing 10 and a lightweight resin for the cover body 30.
(3) In the above embodiment, an example is described in which the manifold housing 10 of the cooling module 1 is formed by a single housing (a single member). Alternatively, the manifold housing may be formed by a plurality of members, for example, two members (an upper housing and a lower housing, or the like) being resin-bonded to each other in the Z direction.
(4) In the above embodiment, an example is described in which the first water pump 2, the second water pump 3, the first rotary valve 4, and the second rotary valve 5 are used as auxiliary devices attached to the cooling module 1, and this disclosure is not limited thereto. The cooling module 1 may be equipped with another auxiliary device. Other examples of an auxiliary device include pumps such as a battery pump and a powertrain pump, a chiller, an electric heater, a filter, an aerator, a valve, a connector, a fan, and a radiator.
(5) In the above embodiment, as an example, the cooling module 1 is configured such that the first inflow port 11, the second inflow port 12, the first outflow port 13, the second outflow port 14, the third inflow port 21, the fourth inflow port 22, the third outflow port 23, the fourth outflow port 24, the fifth outflow port 16, and the flow path pipes 15, 17, 25, and 26 are exposed to the outside. Alternatively, the cooling module 1 may be configured such that a flow path including one or more among these is formed inside the manifold housing 10.
(6) In the above embodiment, although an example is described in which the cooling module 1 includes a plurality of rotary valves 4 and 5, the cooling module 1 may include a single rotary valve.
(7) In the above embodiment, an example is described in which the single cover body 30 covers the openings 10Aa and 20Aa of the plurality of accommodation portions 10A and 20A. Alternatively, a plurality of cover bodies 30 may cover the openings of the plurality of accommodation portions, respectively.

### Overview of Above-described Embodiment

Hereinafter, in the above embodiment, the following configuration is conceivable.
<1> One aspect of the cooling module (1) includes: a manifold housing (10) made of resin and including an accommodation portion (10A, 20A) having an opening (10Aa, 20Aa) and at least a part (15A, 16A, 17A, 21A, 25A) of a flow path (15, 16, 17, 21, 25) allowing a fluid to flow therethrough; a rotary valve (4, 5) accommodated in the accommodation portion (10A, 20A) via the opening (10Aa, 20Aa); and a cover body (30) made of resin and resin-bonded to the manifold housing (10) to cover the opening (10Aa, 20Aa) of the accommodation portion (10A, 20A) and the part (15A, 16A, 17A, 21A, 25A) of the flow path (15, 16, 17, 21, 25).

According to the present embodiment, in the cooling module (1), the manifold housing (10) made of resin includes the accommodation portion (10A, 20A) and at least a part (15A, 16A, 17A, 21A, 25A) of the flow path (15, 16, 17, 21, 25) that allows a fluid to flow therethrough, the rotary valve (4, 5) is accommodated in the accommodation portion (10A, 20A), and the opening (10Aa, 20Aa) of the accommodation portion (10A, 20A) and the part (15A, 16A, 17A, 21A, 25A) of the flow path (15, 16, 17, 21, 25) are covered with the cover body (30), which is made of resin and resin-bonded to the manifold housing (10). Accordingly, the cooling module (1) does not require a separate member such as a bolt for joining the manifold housing (10) and the cover body (30). As a result, the height of the cooling module (1) can be reduced, and the number of components can also be reduced.

<2> In the cooling module (1) according to <1>, the manifold housing (10) and the cover body (30) may be formed of a first resin material, and the manifold housing (10) and the cover body (30) may be resin-bonded to each other by a second resin material different from the first resin material.

According to the present embodiment, in the cooling module (1), the first resin material forming the manifold housing (10) and the cover body (30) is different from the second resin material used to resin-bond the manifold housing (10) and the cover body (30). Therefore, the cooling module (1) can be molded via, for example, die slide injection (DSI). When the DSI method is used, components of the rotary valve (4, 5), such as a valve rotor (41, 51), a rotor seal (42, 52), and a rod seal (43, 53), are inserted into the accommodation portion (10A, 20A) before a DSI step is performed. Thereafter, the manifold housing (10) and the cover body (30) can be resin-bonded to each other by the DSI method, and the opening of the accommodation portion (10A, 20A) can be covered with the cover body (30). In the case of the DSI method, even if the cooling module (1) is a hollow body having a complicated internal structure, the cooling module (1) can be molded with high accuracy.

<3> In the cooling module (1) according to <1> or <2>, the manifold housing (10) may be implemented by a single component.

The manifold housing may also be formed, for example, by resin-bonding a plurality of components. However, in this case, a resin bonding step is required when the manifold housing is molded. In addition, when a flow path formed inside the manifold housing is formed over the plurality of components, a dead space is likely to be generated in the flow path. On the other hand, since the manifold housing (10) is a single member as in the present embodiment, the resin bonding step is not required when the manifold housing (10) is molded, and the dead space can be prevented in the flow path formed inside the manifold housing (10).

<4> In the cooling module (1) according to <1> or <2>, the manifold housing (10) may include a plurality of accommodation portions (10A, 20A) and a part (15A, 16A, 17A, 21A, 25A) of a plurality of flow paths (15, 16, 17, 21, 25), and the single cover body (30) may be resin-bonded to the manifold housing (10) to cover the openings (10Aa, 20Aa) of the plurality of accommodation portions (10A, 20A) and the part (15A, 16A, 17A, 21A, 25A) of the plurality of flow paths (15, 16, 17, 21, 25).

According to the present embodiment, the single cover body (30) is resin-bonded to the manifold housing (10) to cover the openings (10Aa, 20Aa) of the plurality of accommodation portions (10A, 20A) and the part (15A, 16A, 17A, 21A, 25A) of the plurality of flow paths (15, 16, 17, 21, 25). Accordingly, the cooling module (1) can easily reduce the number of components.

## Claims

1. A cooling module (1) comprising:
a manifold housing (10) made of resin and including
an accommodation portion (10A, 20A) having an opening (10Aa, 20Aa), and
at least a part (15A, 16A, 17A, 21A, 25A) of a flow path (15, 16, 17, 21, 25) allowing a fluid to flow therethrough;
a rotary valve (4, 5) accommodated in the accommodation portion via the opening; and
a cover body (30) made of resin and resin-bonded to the manifold housing to cover the opening of the accommodation portion and the part of the flow path.

2. The cooling module according to claim 1, wherein
the manifold housing and the cover body are formed of a first resin material, and
the manifold housing and the cover body are resin-bonded to each other by a second resin material different from the first resin material.

3. The cooling module according to claim 1 or 2, wherein
the manifold housing is implemented by a single component.

4. The cooling module according to claim 1 or 2, wherein
the manifold housing includes a plurality of the accommodation portions and a part of a plurality of the flow paths, and
the single cover body is resin-bonded to the manifold housing to cover the openings of the plurality of the accommodation portions and the part of the plurality of the flow paths.
